(19) Europäisches Patentamt
European Patent Office
Office européen des brevets

(11) **EP 1 515 431 B1**

(12) **EUROPEAN PATENT SPECIFICATION**

(45) Date of publication and mention
of the grant of the patent:
**24.09.2008 Bulletin 2008/39**

(51) Int Cl.:
**H03F 1/32** (2006.01)   **H03F 3/45** (2006.01)
**H03G 3/30** (2006.01)

(21) Application number: **03425589.3**

(22) Date of filing: **11.09.2003**

(54) **Step gain-variable CMOS amplifier**

CMOS-Verstärker mit stufenförmig veränderlicher Verstärkung

Amplificateur CMOS avec gain variable par étapes

(84) Designated Contracting States:
**DE FR GB IT**

(43) Date of publication of application:
**16.03.2005 Bulletin 2005/11**

(73) Proprietor: **STMicroelectronics S.r.l.**
**20041 Agrate Brianza (Milano) (IT)**

(72) Inventors:
• **Gaeta, Marco**
**26866 Sant'Angelo Lodigiano (IT)**

• **Bollati, Giacomino**
**29015 Castel San Giovanni (IT)**

(74) Representative: **Pellegri, Alberto et al**
**Società Italiana Brevetti S.p.A.**
**Via Avegno, 6**
**21100 Varese (IT)**

(56) References cited:
WO-A-03/023954     US-B1- 6 198 329
US-B1- 6 396 339     US-B1- 6 429 690

**Description**

The present invention relates in general to integrated CMOS analog circuits and in particular to a differential amplifier the gain which may be programmed stepwise through pre-established fixed steps.

Frequently in signal processing systems it is useful to be able to keep the output signal within a fixed voltage amplitude window upon the varying of the amplitude of the input signal.

In other cases, it may be useful to be able to keep the input signal within a fixed voltage amplitude window upon the varying of the amplitude of the output signal.

Moreover, harmonic distortion should remain optimally reduced throughout the range of selectable gain of the amplifier.

The US patent No. 6,429,690 discloses a programmable linear transconductor circuit having two groups of input transistors that may be biased by one or the other current source of the circuit by two respective groups of switches.

To these requirements, an outstandingly effective solution has been found, in the form of a CMOS amplifier structure, the gain of which is given by a "$gm_i/gm_0$ stage" in which $gm_i$ may be changed by programming.

The step gain-variable CMOS differential amplifier of this invention is based on the basic structure of a differential amplifier including an input pair of transistors, a bias current generator connected between a common source node of the input pair of transistors and the ground node of the circuit and a pair of load transistors of same type of conductivity of the inpuit pair connected between the supply voltage node and, respectively, to the drain nodes of the input transistors. Essentially, the novel structure according to this invention is as defined in claim 1.

The invention is defined in the annexed claims.

**Figure 1** shows a step gain-variable CMOS amplifier according to a first embodiment of this invention.
**Figure 2** shows a step gain-variable CMOS amplifier according to an alternative embodiment of this invention.
**Figure 3a** shows the transfer characteristic (v-i) of the effective transconductor pair for different gain settings of the amplifier of figure 1.
**Figure 3b** shows the transfer characteristics (i-v) of the transresistor M9-M10 of figure 1 (or of the effective transresistor M3-M 10 of figure 2).

For better illustrating the features and effectiveness of this invention, significative embodiments will now be described in detail.

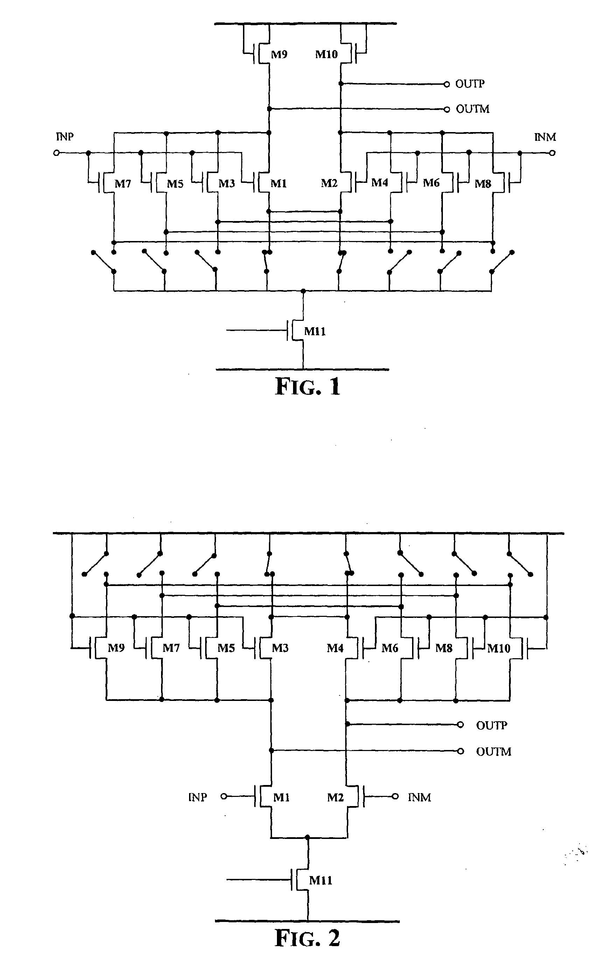

Figure 1 shows a $gm_i/gm_0$ amplifier structure according to a first embodiment.

Notably, the gain is given by:

$$Gain = \frac{gm_1}{gm_9} \cong \frac{\sqrt{\left(\frac{W}{L}\right)_1 \cdot I_1}}{\sqrt{\left(\frac{W}{L}\right)_9 \cdot I_9}} \qquad (1)$$

and the bandwidth by:

$$Bandwidth \cong \frac{gm_9}{C_{out}} \cong \frac{\sqrt{\left(\frac{W}{L}\right)_9 \cdot I_9}}{C_{out}} \qquad (2)$$

where $C_{out}$ is the output capacitance. Being $gm_9$ fixed, the bandwidth remains practically constant for every programmed gain. A tolerably minor variation ($\sim$1%) may be due to different bias conditions of the resultant (effective) transistors of the input pairs.

An important formula about the so-called overdrive voltage of the transistors ($Vov = Vgs - Vth$) is given in equation 3.

$$V_{ov} \cong \frac{I}{gm} \cong \sqrt{\frac{I}{(W/L)}} \qquad\qquad (3)$$

$gm_9$ and $I$ being fixed, the gain of the amplifier is programmed by changing the width term W of the aspect ratio W/L of the resultant input transistors by switching on and off additional transistor pairs M3-M4, M5-M6, M7-M8, etc., in parallel to a "core" differential pair, for example M1-M2, that are always included in the circuit.

Most commonly a dB-linear variable gain amplifier is used to provide an output signal of a certain amplitude independently from the amplitude of the input signal. Therefore, the minimum gain configuration is used when the amplitude of the input signal is at its maximum (i.e. when the highest linearity of the amplifier is required). According to this embodiment, the overdrive of the transconductor (composed of the M1-M2 "core" input pair to which other pairs up to the M7-M8 pair of figure 1 are selectively connected in parallel) is proportional to the input signal amplitude.

According to this first embodiment of Figure 1, for the minimum programmable gain, the minimum transistor width is used for the input pair, let's say W1. Being the current constant, that is independent from the programmed gain, when the resultant input transistor has the minimum width, the input differential pair has the maximum overdrive voltage Vov1 (i.e. the highest linearity).

For increasing the gain, more input transistor pairs are coupled to the functioning circuit and the width of the effective transistors of the input pair W progressively may become *W1 + W3 + W5 + W7* and above. By way of an example, let's suppose that the minimum gain (obtained with an input pair sized W1 working with a voltage overdrive Vov1) is used for an input voltage swing Vinputl. If the input voltage swing decreases by a factor 2 (Vinput2=(1/2) *Vinput1), the gain needs to be incremented by the same factor 2. Therefore, the width of the input pairs needs to be incremented by 4 times the minimum width W1, and consequently, the overdrive voltage of the resultant (effective) input pair (given by equation 3) reduces to Vov2= (1/2)*Vov1.

As noted above, the voltage overdrive of the input pair is inversely proportional to the programmed gain while, according to this embodiment, the voltage overdrive of the load pair of transistors remains fixed.

This feature of the amplifier of this invention according to this first embodiment, is particularly suited for applications where the purpose of the amplifier is to keep fixed the amplitude of the output voltage. In this embodiment, in fact, the linearity of each differential pair of transistors (that is of the effective input transistor pair and of the load transistor pair) is always proportional to the amplitude of the respectively applied signal (that is: the input signal for the effective input pair, the output signal for the output pair).

For applications working with a substantially fixed input voltage swing and output voltage swing proportional to the gain, it is possible to use the same concept of "fixed linearity", by keeping fixed the effective width of the transistors of the input pair and making the gain programmable by changing the effective width of the transistors of the load pair (which may be referred to also as output transistor pair).

This alternative embodiment of the amplifier according to this invention is shown in Figure 2.

Also in this alternative embodiment, all the previous considerations are valid except for the bandwidth that does not remain constant. In fact the term $gm_9$ in equation 2 is no longer constant, corresponding in this case to the sum of the gm(s) of the pairs of load transistors that are programmably connected into the functioning circuit of the amplifier.

In particular applications, such a behaviour of the amplifier according to this alternative embodiment may provide important peculiar advantages.

By realizing an amplifier in which the linearity of each "stage" is proportional to its voltage swing has the advantage of partially compensating distortion.

As an example, consider a unit gain stage. The resultant (effective) load pair of transistors acts as a transresistor, and the transfer characteristic (i-v) is the inverse of the (v-i) transfer characteristic of the input pair of transistors, as long as their overdrive is the same.

Intuitively, the distortion due to the compression effects of the v-i characteristic of the input mos transistors is deleted by the contrary distortion due to the expansion effects of the i-v characteristic of the output pair of transistors.

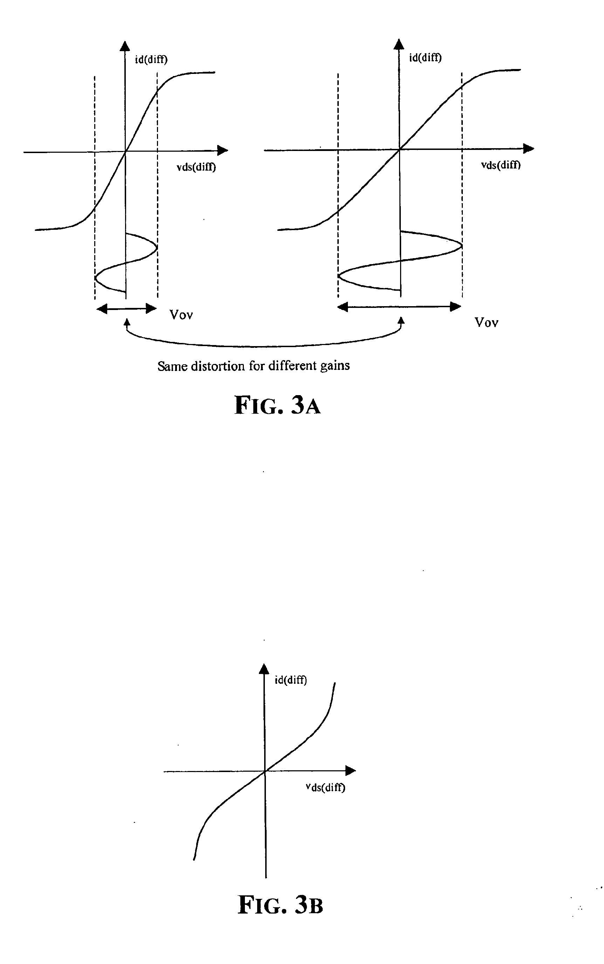

This is graphically illustrated in Figure 3a.

Of course, when the gain is different from "1", input and load (output) transistors need to have different overdrives because they handle signals of different amplitudes. By supposing that for example the gain be -6dB, the output (load) mos transistors works with a signal of half amplitude compared to the input mos transistors, and correspondingly they need a halved overdrive voltage in order to produce the same distortion for compensation purposes.

If $gm_1$ is the transconductance of the input transistors and $gm_2$ that of the output transistors, the overdrive ratio is given by the following equation 4:

$$\frac{Vov_1}{Vov_2} = \frac{1}{Gain} = \frac{gm_2}{gm_1} \qquad\qquad (4)$$

Figure 3a shows how the linearity of the input pairs is proportional to the input signal. In this way the distortion may be optimized and maintained practically constant for every gain setting.

As already mentioned above, Figure 3b shows that the load transistor pair (output transresistor) applies a distorsion of opposite sign compared to the distorsion introduced by the transistors of the input pair (input transconductor) and that may be made substantially equal for an effective compensation. Through a correct combination of the two characteristics (ideally leading to a resultant substantially straight-line characteristic for null distorsion), harmonic distortion may be easily optimized.

The circuit of the variable gain amplifier of this invention may be seen as a coarsely variable gain amplifier because of the step-by-step gain changes that may be implemented, as compared to a classical continuous gain regulation amplifier.

However, an advantage of the coarsely variable gain amplifier of this invention is given by the fact that the gain is changed by switching transistor pairs in or out of the operating circuit, thus making possible to maintain optimal overdrive conditions (same THD) under every condition of operation.

This property allows a significant reduction of the power compared to other solutions because of the linearity of the building blocks of the amplifier according to this invention, namely: the input transconductor stage and the output transresistor linearities are lower than the resultant linearity of the whole amplifier (if a lower linearity of the two stages may be tolerated because of the implemented compensation, it is possible to save power). By contrast, if, for example, an amplifier with resistive loads (that is having high linearity) is considered, the linearity of the amplifier corresponds to the linearity of the input transconductor.

## Claims

1. Step gain-variable CMOS differential amplifier, including an input pair of transistors (M1, M2) of a first type of conductivity, a bias current generator (M11) connected between a common source node of said input pair of transistors (M1, M2) and a ground node, a load pair of transistors (M9, M10) of the same type of conductivity of said input pair of transistors (M1, M2), connected between a supply voltage node and, respectively, to drain nodes of said input pair of transistors (M1, M2), **characterized in that** it comprises:

   a plurality of pairs of transistors (M3, M4; M5, M6; M7, M8), which are connectable in parallel with either said input pair of transistors (M1, M2) or with said load pair of transistors (M9, M10) by programmably closing a plurality of path selecting pairs of switches which are coupled either to said common source node of said input pair of transistors (M1, M2) or to said supply voltage node.

2. The step gain-variable CMOS differential amplifier according to claim 1, wherein said load pair of transistors (M9, M10) has a fixed geometry and said plurality of pairs of transistors (M3, M4; M5, M6; M7, M8), are connectable in parallel with said input pair of transistors (M1, M2) by programmably closing a plurality of path selecting pairs of switches which are coupled to said common source node, for providing a constant bandwidth for all gain settings and compensating distortion of said differential amplifier.

3. The step gain-variable CMOS differential amplifier according to claim 1, wherein said input pair of transistors (M1, M2) has a fixed geometry and said plurality of pairs of transistors (M3, M4; M5, M6; M7, M8), are connectable in parallel with said load pair of transistors (M9, M10) by programmably closing a plurality of path selecting pairs of switches which are coupled to said supply voltage node, for providing gain adaptivity with constancy of the amplitude of the input signal and compensating distortion for all gain settings of said differential amplifier.

4. The step gain-variable CMOS amplifier according to claim 1, wherein all said transistors have an aspect ratio of the minimum width of definition of the fabrication process.

## Patentansprüche

1. CMOS-Differenzverstärker mit stufenförmig veränderlicher Verstärkung, der umfaßt: ein Eingangstransistorpaar (M1, M2) eines ersten Leitfähigkeitstyps, einen Vorstromgenerator (M11), der zwischen einem gemeinsamen Source-Knoten des Eingangstransistorpaars (M1, M2) und einem Masseknoten geschaltet ist, ein Lasttransistorpaar (M9, M10) desselben Leitfähigkeitstyps wie das Eingangstransistorpaar (M1, M2), das zwischen einem Versorgungsspannungsknoten und jeweils Drain-Knoten des Eingangstransistorpaars (M1, M2) geschaltet ist, **dadurch gekennzeichnet, daß** er aufweist:

mehrere Transistorpaare (M3, M4; M5, M6; M7, M8), die entweder mit dem Eingangstransistorpaar (M1, M2) oder mit dem Lasttransistorpaar (M9, M10) parallel schaltbar sind, indem programmierbar mehrere Wegauswahlschalterpaare geschlossen werden, die entweder mit dem gemeinsamen Source-Knoten des Eingangstransistorpaars (M1, M2) oder mit dem Versorgungsspannungsknoten verbunden sind.

2. CMOS-Differenzverstärker mit stufenförmig veränderlicher Verstärkung nach Anspruch 1, wobei das Lasttransistorpaar (M9, M10) eine feste Geometrie aufweist und die mehreren Transistorpaare (M3, M4; M5, M6; M7, M8) mit dem Eingangstransistorpaar (M1, M2) parallel schaltbar sind, indem programmierbar mehrere Wegauswahlschalterpaare geschlossen werden, die mit dem gemeinsamen Source-Knoten verbunden sind, um eine konstante Bandbreite für alle Verstärkungseinstellungen bereitzustellen und eine Verzerrung des Differenzverstärkers zu kompensieren.

3. CMOS-Differenzverstärker mit stufenförmig veränderlicher Verstärkung nach Anspruch 1, wobei das Eingangstransistorpaar (M1, M2) eine feste Geometrie aufweist und die mehreren Transistorpaare (M3, M4; M5, M6; M7, M8) mit dem Lasttransistorpaar (M9, M10) parallel schaltbar sind, indem programmierbar mehrere Wegauswahlschalterpaare geschlossen werden, die mit dem Versorgungsspannungsknoten verbunden sind, um eine Verstärkungsanpassungsfähigkeit bei konstanter Amplitude des Eingangssignals bereitzustellen und eine Verzerrung für alle Verstärkungseinstellungen des Differenzverstärkers zu kompensieren.

4. CMOS-Verstärker mit stufenförmig veränderlicher Verstärkung nach Anspruch 1, wobei alle Transistoren ein Seitenverhältnis der minimalen Definitionsbreite des Fertigungsverfahrens aufweisen.


**Revendications**

1. Amplificateur différentiel CMOS à gain variable par échelons, comprenant une paire de transistors d'entrée (M1, M2) d'un premier type de conductivité, un générateur de courant de polarisation (M11) connecté entre un noeud de source commun de la paire de transistors d'entrée (M1, M2) et un noeud de masse, une paire de transistors de charge (M9, M10) du même type de conductivité que la paire de transistors d'entrée (M1, M2), connectée entre un noeud de tension d'alimentation et des noeuds de drain respectifs de la paire de transistors d'entrée (M1, M2), **caractérisé en ce qu'**il comprend :

une pluralité de paires de transistors (M3, M4 ; M5, M6 ; M7, M8), qui sont connectables en parallèle avec la paire de transistors d'entrée (M1, M2) ou avec la paire de transistors de charge (M9, M10) en fermant de façon programmable une pluralité de paires de commutateurs de sélection de trajet qui sont couplées au noeud de source commun de la paire de transistors d'entrée (M1, M2) ou au noeud de tension d'alimentation.

2. Amplificateur différentiel CMOS à gain variable par échelons selon la revendication 1, dans lequel la paire de transistors de charge (M9, M10) a une géométrie fixe et ladite pluralité de paires de transistors (M3, M4 ; M5, M6 ; M7, M8) est connectable en parallèle avec la paire de transistors d'entrée (M1, M2) en fermant de façon programmable une pluralité de paires de commutateurs de sélection de trajet qui sont couplées au noeud de source commun, pour assurer une largeur de bande constante pour tous les réglages de gain et pour compenser la distorsion de l'amplificateur différentiel.

3. Amplificateur différentiel CMOS à gain variable par échelons selon la revendication 1, dans lequel la paire de transistors d'entrée (M1, M2) a une géométrie fixe et ladite pluralité de paires de transistors (M3, M4 ; M5, M6 ; M7, M8) est connectable en parallèle avec la paire de transistors de charge (M9, M10) en fermant de façon programmable une pluralité de paires de commutateurs de sélection qui sont couplées au noeud de tension d'alimentation, pour assurer une adaptabilité de gain avec constance de l'amplitude du signal d'entrée et pour compenser la distorsion pour tous les réglages de gain de l'amplificateur différentiel.

4. Amplificateur CMOS à gain variable par échelons selon la revendication 1, dans lequel tous les transistors ont un facteur de forme en accord avec la largeur minimum de définition du processus de fabrication.

**FIG. 1**

**FIG. 2**

Same distortion for different gains

**FIG. 3A**

**FIG. 3B**

**EP 1 515 431 B1**

**REFERENCES CITED IN THE DESCRIPTION**

**Patent documents cited in the description**

- US 6429690 B